Europäisches Patentamt

European Patent Office

Office européen des brevets

(19)

(11) Numéro de publication : **0 120 749**
**B1**

(12) FASCICULE DE BREVET EUROPÉEN

(45) Date de publication du fascicule du brevet :
27.05.87

(51) Int. Cl.⁴ : **G 01 R 31/34**

(21) Numéro de dépôt : 84400409.3

(22) Date de dépôt : 01.03.84

(54) Procédé et dispositif de mesure du glissement d'un moteur.

(30) Priorité : 01.03.83 FR 8303307

(43) Date de publication de la demande :
03.10.84 Bulletin 84/40

(45) Mention de la délivrance du brevet :
27.05.87 Bulletin 87/22

(84) Etats contractants désignés :
AT BE CH DE GB IT LI LU NL SE

(56) Documents cités :
FR-A- 1 566 188
FR-A- 1 597 456
FR-A- 2 514 146

(73) Titulaire : **LA TELEMECANIQUE ELECTRIQUE**
**33 bis, avenue du Maréchal Joffre**
**F-92000 Nanterre (FR)**

(72) Inventeur : **Conrath, Christian Résidence d'Emeraude**
**Bâtiment Rubis A3 Avenue du Riou Blanquet**
**F-06130 Grasse (FR)**

(74) Mandataire : **Marquer, Francis et al**
**CABINET MOUTARD 35, avenue Victor Hugo Rési-**
**dence Champfleury**
**F-78180 Voisins-le-Bretonneux (FR)**

**0 120 749**

## Description

La présente invention concerne un procédé et un dispositif de mesure du glissement d'un moteur.

Il est déjà connu, par FR-A-1 566 188 de déterminer le glissement d'un moteur asynchrone par un procédé mettant en œuvre des moyens de mesurer l'impédance directe du moteur, à partir des seules grandeurs électriques sinusoïdales, tensions et courants du stator.

Selon le procédé connu par FR-A-1 566 188 :

— ou bien les grandeurs électriques sinusoïdales alimentent respectivement un filtre de tension directe et un filtre de courant direct, reliés à des réseaux passifs linéaires dont les grandeurs de sortie sont appliquées à un quotientmètre et/ou phasemètre qui délivrent une grandeur continue analogique fonction du module et/ou de l'argument de l'impédance du moteur, ladite grandeur continue analogique étant ensuite appliquée à un dispositif de mesure ;

— ou bien les grandeurs électriques sinusoïdales sont appliquées à un relais d'impédance permettant, à partir d'un élément électromécanique ou statique de comparaison de module ou de phase, d'obtenir toute caractéristique d'impédance rectiligne ou circulaire.

L'invention a pour objet un procédé plus simple que celui du brevet susvisé, mis en œuvre par un microprocesseur, et ayant pour principal avantage de laisser le microprocesseur suffisamment libre pour exécuter d'autres tâches, comme la commande des convertisseurs d'alimentation du moteur.

Selon l'invention, le procédé de détermination du glissement g d'un moteur asynchrone, alimenté par une source polyphasée à pulsation variable, sans utilisation d'un détecteur tachymétrique, à l'aide de mesures effectuées à ses bornes statoriques, est caractérisé en ce qu'il comporte, dans une phase préliminaire, la détermination préliminaire de la résistance statorique $R_1$ à partir de mesures effectuées sur le moteur à l'arrêt alimenté en courant continu et la détermination préliminaire de la résistance $R_2$ du rotor vue du stator du moteur, rotor bloqué et alimenté par une tension variable de fréquence peu élevée ; dans une phase de fonctionnement, la mesure de la tension $U_c$ et du courant $I_c$ fournis au dispositif alimentant le moteur en fonctionnement ; et le calcul du glissement g à partir des résultats des déterminations préliminaires et de la mesure de la tension et du courant, en utilisant la formule

$$g = \frac{R_2}{\dfrac{U_c}{3\,k^2\,I_c} - R_1}$$

à partir de résistances $R_1$ et $R_2$ mises en mémoire et des mesures de la tension et du courant fournis au moteur.

Le dispositif pour la mise en œuvre du procédé de l'invention est caractérisé en ce qu'il comprend : des premiers moyens qui engendrent un signal proportionnel à la tension continue délivrée en sortie d'un convertisseur de fréquence alimentant le stator du moteur, pour déterminer dans ladite phase préliminaire, par des moyens de calcul, la résistance statorique $R_1$ ; des seconds moyens qui engendrent respectivement un signal proportionnel à la tension continue $U_c$ délivrée en sortie d'un pont redresseur alimentant le convertisseur de fréquence et un signal proportionnel au courant $I_c$ fourni par le réseau au pont redresseur, ledit signal proportionnel au courant fourni par le second moyen étant redressé par un second redresseur avant d'être fourni aux moyens de calcul pour la détermination, soit de la résistance rotorique vue du stator $R_2$ dans ladite phase préliminaire du procédé, soit du glissement g dans ladite phase de fonctionnement par la formule

$$g = \frac{R_2}{\dfrac{U_c}{3\,k^2\,I_c} - R_1}$$

lesdits moyens de calcul commandant par des sorties, le fonctionnement du pont redresseur et du convertisseur de fréquence au cours des phases préliminaires.

D'autres caractéristiques et avantages de l'invention apparaîtront plus clairement à la lecture de la description ci-après, faite en se référant aux dessins annexés, dans lesquels :

La figure 1 représente un circuit constituant l'équivalent électrique d'un moteur ;

La figure 2 est un diagramme vectoriel des courants parcourant les branches du circuit de la figure 1 ;

La figure 3 est un exemple de réalisation d'un dispositif permettant la mise en œuvre du procédé de l'invention.

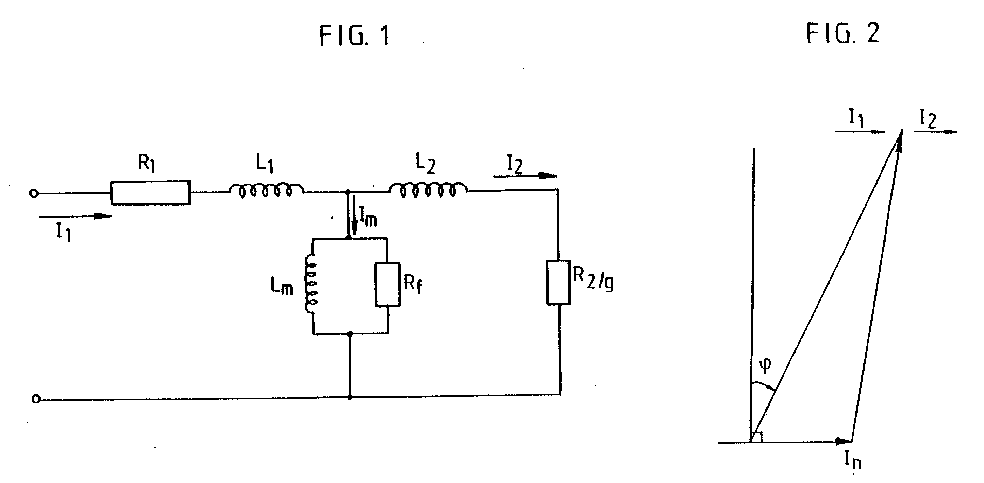

La figure 1 représente un circuit constituant l'équivalent électrique d'une phase d'un moteur asynchrone, vu des bornes du stator, dans lequel $R_1$ représente la résistance du stator, $L_1$ l'inductance de fuite du stator, $L_2$ l'inductance de fuite du rotor, $R_2/g$, la résistance apparente du rotor vue du stator où $R_2$ est la résistance propre du rotor et g le glissement fréquentiel du moteur, $L_m$ l'inductance magnétisante, $R_f$ une résistance représentant les pertes dues au fer. Dans ce circuit équivalent, on peut négliger un certain nombre de facteurs, compte tenu de la qualité des moteurs actuellement fabriqués. Ainsi, les

2

inductances de fuites $L_1$ et $L_2$ sont très faibles et, par conséquent, négligeables ; la résistance $R_f$ représentant les pertes de fer est également très faible et, par conséquent, négligeable. Dans le circuit équivalent, si l'on calcule la puissance active après avoir négligé tous ces termes, on obtient la relation

$$P = 3\left(R_1 I_1^2 - \frac{R_2}{g} I_2^2\right) \qquad (1)$$

Cette puissance active est la seule à intervenir dans le calcul de la puissance réelle transmise au moteur.

D'autre part, si l'on considère le diagramme vectoriel des courants circulant dans le moteur représenté à la figure 2, on a la relation vectorielle :

$$\vec{I}_1 = \vec{I}_2 - \vec{I}_m \qquad (2)$$

$I_m$ étant faible et $\cos \varphi$ proche de 1 en fonctionnement normal, comme représenté à la figure 2, on en déduit que :

$$|I_1| \# |I_2|$$

avec

$$|I_1| = k|I_c| \qquad (3)$$

k est un facteur de forme dépendant du mode de commande du convertisseur de fréquence 2, $I_c$ est le courant continu délivré par le redresseur 3 ce qui permet d'écrire la relation (1) sous la forme suivante :

$$P = 3k^2I_c^2(R_1 + R_2/g) \qquad (4)$$

Si l'on détermine par des mesures, en cours de fonctionnement, d'une part la puissance transmise, qui est égale à la puissance électrique, d'autre part, le courant alimentant le moteur, et si l'on connaît $R_1$ et $R_2$ par des mesures préalables faites à la mise en route, il sera possible de calculer le glissement du moteur et, par la suite, de commander le convertisseur et le redresseur d'alimentation du moteur.

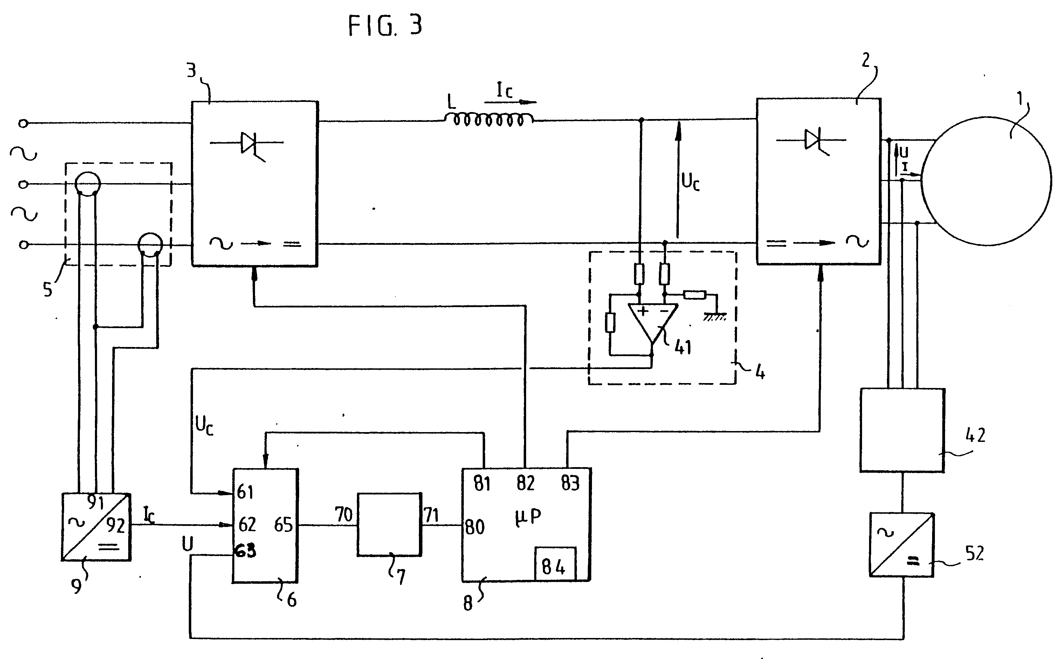

La figure 3 est une vue schématique du dispositif de détermination du glissement d'un moteur 1 et de son application à la commande du dispositif d'alimentation d'un moteur asynchrone polyphasé. Le moteur 1 est alimenté par un dispositif connu 2 qui peut être, soit un convertisseur de fréquence, soit, éventuellement sun gradateur. Un gradateur délivre une tension variable à une fréquence constante, tandis qu'un convertisseur de fréquence délivre une tension et une fréquence variables. Ce convertisseur de fréquence 2 est lui-même alimenté, à travers une inductance de lissage L, par un pont redresseur 3 branché à une alimentation alternative triphasée.

Le convertisseur de fréquence 2 et le redresseur 3 étant réalisés au moyen de ponts d'interrupteurs statiques (par exemple des thyristors), le rendement de ces dispositifs est voisin de l'unité et la puissance électrique fournie au moteur peut être déterminée en mesurant la tension continue $U_c$ délivrée en sortie du redresseur 3 et de l'inductance L, au moyen d'un circuit analogique 4 comportant un amplificateur différentiel 41 monté avec des résistances, de façon connue, pour délivrer à l'entrée 61 d'un multiplexeur 6 un signal proportionnel à la tension continue $U_c$. Le courant fourni au moteur est également mesuré au moyen d'un circuit connu 5 comprenant deux transformateurs de courant montés sur deux des phases du circuit d'alimentation du·redresseur 3 et branchés à l'entrée triple 91 d'un redresseur 9 dont l'unique sortie 92 délivre, à l'entrée 62 du multiplexeur 6, un signal de tension continue proportionnel au courant d'alimentation du moteur. Un circuit analogique 4, comprenant deux amplificateurs différentiels 42, et un redresseur triphasé sans seuil 52 est branché entre les trois phases du moteur à la sortie du convertisseur 2 et alimente l'entrée 63 du multiplexeur 6 par un signal proportionnel à la tension entre deux phases du moteur.

Le courant qui circule dans une phase du moteur se déduit du courant $I_c$ par :

$$I_l = k\, I_c$$

Les circuits à amplificateur différentiel 4 de même que le redresseur triphasé sans seuil 52 sont bien connus de l'homme de métier et peuvent être du type de ceux associant des amplificateurs et des résistances, décrits dans la demande de brevet français déposée en brevet européen le 31 août 1982 sous le n° 82 401 608 3. La sortie 65 du multiplexeur est branchée à l'entrée 70 d'un convertisseur analogique/numérique 7, dont la sortie 71 est branchée à l'entrée 80 d'un microprocesseur 8. La sortie 81 de ce dernier commande le multiplexeur, pour désigner le signal qui sera admis à l'entrée 80. Les sorties 82 et 83 commandent les gâchettes ou les bases des interrupteurs statiques du redresseur 3 et, respectivement, du convertisseur de fréquence 2. Le microprocesseur 8 comprend une mémoire vive 84 qui sert à conserver le résultat des mesures préalables de $R_1$ et $R_2$ effectuées au cours de chaque phase de démarrage du dispositif, ceci permet de tenir compte de l'échauffement du moteur au moment de la phase de démarrage.

En fonctionnement, le dispositif fonctionne en deux étapes. Au cours d'une première étape, dite de démarrage, le microprocesseur commande le convertisseur de fréquence 2 et le redresseur 3, de façon que deux phases du moteur soient alimentées par un courant continu et une tension continue.

Le dispositif reçoit, sur les entrées 63 et 64, des signaux proportionnels à ces grandeurs et le microprocesseur 8, en commandant par 81 la sélection des entrées 63 et 64, reçoit des signaux transformés en valeurs numériques et détermine le rapport $U/I_c$ représentatif de $R_1$. Lorsque $R_1$ a été déterminé, le microprocesseur range la valeur représentative de $R_1$ dans la mémoire vive 84.

Ensuite, le microprocesseur détermine la valeur représentative de $R_2$, qu'il va ranger dans la mémoire 84. Pour cela, le microprocesseur procède à une mesure rotor bloqué en faisant osciller le moteur autour d'une position d'équilibre à une fréquence inférieure à 30 Hz. De façon avantageuse, on choisira une fréquence de 20 Hz. Sachant que la puissance électrique fournie est entièrement dissipée par effet Joule et que le moteur ne peut tourner dans ce cas, on peut considérer le rotor comme bloqué. Ceci fixe par conséquent la valeur du glissement à 1 ; on obtient alors l'équation suivante :

$$P = 3k^2(R_1 + R_2/I)I_c^2 = U_c \cdot I_c$$

d'où l'on déduit :

$$R_1 + R_2 = U_c/3k^2I_c \qquad (5)$$

Dans cette phase de la première étape, le microprocesseur doit donc commander l'onduleur 2 par sa sortie 83, pour alimenter le moteur avec un signal oscillant de fréquence inférieure à 30 Hz, commander, par sa sortie 81, l'entrée des signaux 61 et 62 représentatifs de la tension et du courant fournis et déterminer par le calcul la valeur représentative de $R_2$ en appliquant la relation 5 ; enfin, il doit ranger cette valeur dans la mémoire 84.

Dans une deuxième étape, le moteur étant en fonctionnement, le microprocesseur commande, par 83 et 82, l'onduleur 2 et le redresseur 3, pour alimenter le moteur 1 en fonction des performances demandées à celui-ci.

En cours de fonctionnement, le microprocesseur commande, par 81, l'entrée des données $U_c$ et $I_c$ accessibles en 61 et 62 et applique la formule (4)

$$P = 3K^2I_c^2(R_1 + R_2/g)$$

dans laquelle $P \neq U_c \cdot I_c$

Le microprocesseur, qui connaît la valeur de $R_1$ et de $R_2$, reçoit en entrée les valeurs $U_c$ et $I_c$ et peut donc déterminer, à tout moment du fonctionnement, la valeur du glissement g :

$$g = \cfrac{R_2}{\cfrac{U_c}{3\,k^2\,I_c} - R_1} \qquad (6)$$

La valeur de g déterminée en 6 est une approximation du glissement réel de la machine ; toutefois celle-ci est satisfaisante dans les zones de fonctionnement normal de la machine.

Une fois le glissement déterminé, le microprocesseur 8 tient compte de cette valeur pour modifier le fonctionnement du redresseur 3 et de l'onduleur 2 en changeant les signaux de commande 82 et 83.

## Revendications

1. Procédé de détermination du glissement g d'un moteur asynchrone alimenté par une source polyphasée à pulsation variable, sans utilisation d'un détecteur tachymétrique, à l'aide de mesures effectuées à ses bornes statoriques, caractérisé en ce qu'il comporte, dans une phase préliminaire, la détermination préliminaire de la résistance statorique $R_1$ à partir de mesures effectuées sur le moteur à l'arrêt alimenté en courant continu et la détermination préliminaire de la résistance $R_2$ du rotor vue du stator du moteur, rotor bloqué alimenté par une tension variable de fréquence peu élevée ; dans une phase de fonctionnement la mesure de la tension $U_c$ et du courant $I_c$ fournis au dispositif qui alimente le moteur en fonctionnement ; et le calcul du glissement g à partir des résultats des déterminations préliminaires et de la mesure de la tension et du courant, en utilisant la formule

$$g = \cfrac{R_2}{\cfrac{U_c}{3\,k^2\,I_c} - R_1}$$

à partir de résistances $R_1$ et $R_2$ mises en mémoire et des mesures de la tension et du courant fournis au moteur.

2. Procédé suivant la revendication 1, caractérisé en ce que les valeurs respectives de la résistance statorique $R_1$ et de la résistance $R_2$ du rotor vue du stator du moteur sont redéterminées à chaque démarrage.

3. Dispositif pour la mise en œuvre du procédé selon la revendication 1, caractérisé en ce qu'il comprend : des premiers moyens (42), (52) qui engendrent un signal proportionnel à la tension continue délivrée en sortie d'un convertisseur de fréquence (2) alimentant le stator du moteur, pour déterminer dans ladite phase préliminaire, par des moyens de calcul (6), (7), (8) la résistance statorique $R_1$ ; des seconds moyens 41) et (5) qui engendrent respectivement un signal proportionnel à la tension continue $U_c$ délivrée en sortie d'un pont redresseur (3) alimentant le convertisseur de fréquence (2) et un signal proportionnel au courant $I_c$ fourni par le réseau au pont redresseur (3), ledit signal proportionnel au courant fourni par le second moyen (5) étant redressé par un second redresseur (9) avant d'être fourni aux moyens de calcul (6), (7), (8), pour la détermination, soit de la résistance rotorique vue du stator $R_2$ dans ladite phase préliminaire du procédé, soit du glissement g dans ladite phase de fonctionnement par la formule

$$g = \frac{R_2}{\dfrac{U_c}{3\,k^2\,I_c} - R_1}$$

lesdits moyens de calcul commandant par des sorties (82), (83), le fonctionnement du pont redresseur (3) et du convertisseur de fréquence (2) auc cours des phases préliminaires.

4. Dispositif selon la revendication 3, caractérisé en ce que les moyens de calcul comportent un microprocesseur (8) comprenant une mémoire vive (84), un circuit multiplexeur (6) branché au microprocesseur adressé en (81) par le microprocesseur pour sélectionner l'un des signaux U, $U_c$, $I_c$, U étant la tension entre deux phases du moteur, reçus en entrée, et délivrés par les premiers et seconds moyens (41, 51, 42, 52).

5. Dispositif selon la revendication 3 ou 4, caractérisé en ce que les sorties (82), (83) du microprocesseur (8) commandent le pont redresseur (3) et le convertisseur de fréquence (2) pendant la phase de fonctionnement, en fonction du résultat du calcul du glissement g.

## Claims

1. Process for determining the slip g of an asynchronous motor supplied by a multiphase source with variable pulsation, without the use of a tachometric detector, by means of measurements carried out at its stator terminals, characterized in that it comprises, as a preliminary step, the preliminary determination of the stator resistance $R_1$ starting from measurements carried out on the stopped motor supplied with d-c current, and the preliminary determination of the resistance $R_2$ of the rotor as seen from the stator of the motor, the rotor being locked and supplied with a variable voltage having a comparatively low frequency ; as an operating step, the measurement of the voltage $U_c$ and of the current $I_c$ supplied to the device which feeds the running motor ; and the calculation of the slip g starting from the results of the preliminary determinations and the measurement of the voltage and the current, by using the formula :

$$g = \frac{R_2}{\dfrac{U_c}{3\,k^2\,I_c} - R_1}$$

starting from the stored resistances $R_1$ and $R_2$ and the voltage and current measurements supplied to the motor.

2. Process according to claim 1, characterized in that the respective values of the stator resistance $R_1$ and of the resistance $R_2$ of the rotor as seen from the stator of the motor are determined anew at each start.

3. Device for implementing the process according to claim 1, characterized in that it comprises : first means (42) (52) which generate a signal proportional to the d-c voltage delivered at the output of a frequency converter (2) supplying the stator of the motor, for determining, during said preliminary step, by calculating means (6) (7) (8), the stator resistance $R_1$ ; second means (41) and (5) which respectively generate a signal proportional to the d-c voltage $U_c$ delivered at the output of a rectifier bridge (3) supplying the frequency converter (2) and a signal proportional to the current $I_c$ supplied by the mains to the rectifier bridge (3), said signal, proportional to the current supplied by the second means (5) being rectified by a second rectifier (9) before being supplied to the calculating means (6) (7) (8) for determining either the resistance $R_2$ of the rotor as seen from the stator in said preliminary step of the process or the slip g in said operating step, by the formula

$$g = \frac{R_2}{\dfrac{U_c}{3\,k^2\,I_c} - R_1}$$

said calculating means controlling, through outputs (82) (83), the operation of the rectifier bridge (3) and the frequency converter (2) during the preliminary steps.

4. Device according to claim 3, characterized in that the calculating means comprise a microprocessor (8) including a RAM (84), a multiplexer circuit (6) connected to the microprocessor, addressed at (81) by the microprocessor, for selecting one of the signals U, $U_c$, $I_c$.-U being the voltage acrosss two phases of the motor received at the input and delivered by the first and second means (41, 51, 42, 52).

5. Device according to claim 3 or 4, characterized in that the outputs (82) (83) of the microprocessor (8) control the rectifier bridge (3) and the frequency converter (2) during the operating step as a function of the result of the calculation of the slip g.

**Patentansprüche**

1. Verfahren zur Bestimmung des Schlupfes g eines von einer Mehrphasenquelle mit variabler Schwingung versorgten Asynchronmotors, ohne Verwendung eines Geschwindigkeitsdetektors, mittels an seinen Statorklemmen durchgeführten Messungen, dadurch gekennzeichnet, dass es, in einer einleitenden Phase beinhaltet : die einleitende Bestimmung des Statorwiderstandes $R_1$ ausgehend von am stillstehenden, mit Gleichstrom gespeisten Motor ausgeführten Messungen, und die einleitende Bestimmung des Rotorwiderstandes $R_2$, vom Motorstator aus gesehen, bei angehaltenem Rotor, der mit einer variablen Spannung nicht sehr hoher Frequenz gespeist wird ; in einer Betriebsphase, die Messung der Spannung $U_c$ und des Stroms $I_c$, die an die Vorrichtung angelegt werden, welche den laufenden Motor speist ; und die Berechnung des Schlupfes g, ausgehend von den Ergebnissen der einleitenden Bestimmungen und der Spannungs- und Strommessung, unter Verwendung der Formel

$$g = \frac{R_2}{\dfrac{U_c}{3\,k^2\,I_c} -- R_1}$$

ausgehend von den eingespeicherten Widerständen $R_1$ und $R_2$ und den Messungen der an den Motor angelegten Spannungs- und Stromwerte ;

2. Verfahren nach Anspruch 1, dadurch gekennzeichnet, dass die entsprechenden Werte des Statorwiderstandes $R_1$ und des vom Motorstator aus gesehenen Rotorwiderstandes $R_2$ bei jedem Anlaufen neu bestimmt werden.

3. Vorrichtung zur Durchführung des Verfahrens nach Anspruch 1, dadurch gekennzeichnet, dass sie enthält : erste Mittel (42) (52), die ein Signal hervorbringen, das proportional ist zur am Ausgang eines Frequenzwandlers (2) erhaltenen Gleichspannung, welche den Motorstator speist, um, in besagter einleitenden Phase, durch Berechnungsmittel (6) (7) (8) den Statorwiderstand $R_1$ zu bestimmen ; zweite Mittel (41) und (5), die jeweils ein Signal hervorbringen, proportional zur am Ausgang einer Gleichrichterbrücke (3) erhaltenen Gleichspannung $U_c$, welche den Frequenzwandler (2) speist und ein Signal proportional zum Strom $I_c$, der vom Netz an die Gleichrichterbrücke (3) angelegt wird, wobei besagtes Signal, das proportional ist zum vom zweiten Mittel (5) gelieferten Strom, von einem zweiten Gleichrichter (9) gleichgerichtet wird, bevor es an die Berechnungsmittel (6) (7) (8) angelegt wird, zur Bestimmung, entweder des vom Stator aus gesehenen Rotorwiderstandes $R_2$ in besagter einleitenden Phase des Verfahrens, oder des Schlupfes g in besagter Betriebsphase durch die Formel

$$g = \frac{R_2}{\dfrac{U_c}{3\,k^2\,I_c} - R_1}$$

wobei besagte Berechnungsmittel durch Ausgänge (82) (83) die Wirkungsweise der Gleichrichterbrücke (3) und des Frequenzwandlers (2) im Laufe der einleitenden Phase steuern.

4. Vorrichtung nach Anspruch 3, dadurch gekennzeichnet, dass zu den Berechnungsmitteln ein Mikroprozessor (8) gehört mit einem Lebendspeicher (84), ein Multiplikationskreis (6), der an den Mikroprozessor angeschlossen ist und von diesem bei (81) angezapft wird, um eines der Signale U, $U_c$, $I_c$ auszuwählen, wobei U die Spannung zwischen zwei Motorphasen ist, die am Eingang aufgenommen und von den ersten und zweiten Mitteln (41, 51, 42, 52) ausgegeben werden.

5. Vorrichtung nach Anspruch 3 oder 4, dadurch gekennzeichnet, dass die Ausgänge (82) (83) des Mikroprozessors (8) die Gleichrichterbrücke (3) und den Frequenzwandler (2) während der Betriebsphase gemäss des Resultats der Berechnung des Schlupfes g steuern.

FIG. 1

FIG. 2

0 120 749

FIG. 3

0 120 749